Europäisches Patentamt

European Patent Office

Office européen des brevets

(11) Numéro de publication: **0 306 370**
**A1**

## (12) DEMANDE DE BREVET EUROPEEN

(21) Numéro de dépôt: 88402013.2

(22) Date de dépôt: 03.08.88

(51) Int. Cl.4: **H 01 L 47/02**
**H 03 B 19/14**

(30) Priorité: 05.08.87 FR 8711143

(43) Date de publication de la demande:
08.03.89 Bulletin 89/10

(84) Etats contractants désignés: **DE GB NL**

(71) Demandeur: **THOMSON HYBRIDES ET MICROONDES**
**173, bld Haussmann**
**F-75008 Paris (FR)**

(72) Inventeur: **Gloanec, Maurice**
**Thomson-CSF SCPI-19, avenue de Messine**
**F-75008 Paris (FR)**

(74) Mandataire: **Taboureau, James et al**
**THOMSON-CSF SCPI 19, avenue de Messine**
**F-75008 Paris (FR)**

(54) Dispositif triode Gunn, diviseur de fréquence et oscillateur utilisant ce dispositif Gunn.

(57) L'invention concerne une triode Gunn, fonctionnant en diviseur dynamique de fréquence programmable, ou en oscillateur VCO.

La triode Gunn est composée d'une couche (1) de matériau III V (Ga As, In P) et elle porte trois métallisations d'anode (A), cathode (K) et grille (G). Selon l'invention, d'abord, la couche (1) a, entre anode et grille, une largeur non uniforme : elle est trapézoïdale ou limitée par deux hyperboles (14, 15). Ensuite, aux tensions continues de polarisation de grille ($V_{GK}$) ou d'anode ($V_{AK}$) est superposée une tension de commande alternative ($V_{HF}$) qui est une harmonique de la fréquence d'oscillation libre de la triode. Le rang de division est égal au rang de l'harmonique. Ajustage de la fréquence de sortie par vernier sur la fréquence de l'harmonique.

Application aux oscillateurs commandés en tension (VCO), aux diviseurs dynamiques programmables, ou aux boucles d'asservissement de fréquence, aux circuits intégrés.

FIG_9

EP 0 306 370 A1

**Description**

## DISPOSITIF TRIODE GUNN, DIVISEUR DE FREQUENCE ET OSCILLATEUR UTILISANT CE DISPOSITIF GUNN

La présente invention concerne un dispositif triode Gunn, de géométrie trapézoïdale, fonctionnant en diviseur de fréquence dynamique, à rang fixe et variable, dans les très hautes fréquences, jusque 60 GHz.

Le phénomène de transfert d'électrons, ou effet Gunn, est connu depuis 1963, date à laquelle J. B. Gunn découvrit que, dans un barreau de matériau III-V tel que Ga As ou In P, dopé de façon uniforme de type n, et polarisé entre anode et cathode, le courant oscille lorsque le champ électrique croit au-delà d'un certain seuil : à chaque oscillation correspond un "paquet" d'électrons, ou domaine, qui quitte la cathode et est transféré vers l'anode. L'oscillation peut être contrôlée au moyen d'une électrode supplémentaire dite grille.

C'est pourquoi les principales applications connues à ce jour concernent des oscillateurs à fréquence fixe ou très légèrement ajustable.

Selon l'invention, un dispositif triode Gunn, comportant une couche de matériau III-V de section non-uniforme, vue en plan entre anode et cathode, fonctionne en diviseur de fréquence si on superpose, à une tension continue appliquée sur la grille ou l'anode, une tension alternative dont la fréquence est une harmonique, d'ordre supérieur, de la fréquence d'oscillation libre du dispositif Gunn. Par fréquence d'oscillation libre, on entend la fréquence à laquelle oscille la triode Gunn, pour une tension continue $V_{AK}$ donnée, et pour une tension continue donnée sur la grille.

De façon plus précise, l'invention concerne un dispositif triode Gunn, fonctionnant à très hautes fréquences (1 à 60 GHz), et comportant, supportée par un substrat, une couche de matériau semiconducteur de la famille III-V, munie de trois métallisations, anode à une première extrêmité de la couche, cathode à une deuxième extrêmité de la couche, et grille à proximité de la cathode, ce dispositif ayant une fréquence d'oscillation libre lorsqu'il est polarisé par une première tension continue ($V_{AK}$) entre anode et cathode, et par une deuxième tension continue ($V_{GK}$) entre grille et cathode, et étant caractérisé en ce que :
- la couche de matériau semiconducteur, située entre les métallisations d'anode et de grille a une largeur non uniforme, l'anode étant plus large que la grille,
- le dispositif est polarisé par une tension de commande alternative superposée soit à la première tension continue $V_{AK}$, soit à la deuxième tension continue $V_{GK}$, ladite tension alternative ayant une fréquence qui est une harmonique de la fréquence d'oscillation libre de la triode Gunn.

L'invention sera mieux comprise par la description détaillée qui en est donnée maintenant, en s'appuyant sur les figures jointes en annexe, qui représentent :
- fig. 1 : vue en coupe d'un dispositif triode Gunn, selon l'art connu,
- fig. 2 : courbe donnant la vitesse des porteurs de charges en fonction du champ électrique, dans l'effet Gunn,
- fig. 3 : courbe donnant le courant de propagation d'un domaine, après une impulsion sur la grille, dans l'effet Gunn,
- fig. 4 : courbe d'oscillation d'une triode Gunn, soumise à une polarisation continue, telle que sous la grille E > Ec.
- fig. 5 : vue en plan d'une triode Gunn, de section trapézoïdale entre anode et cathode, selon l'art connu,
- fig. 6 : courbe donnant le champ électrique en fonction de la distance x à partir de la grille, dans une triode Gunn de section trapézoïdale,
- fig. 7 : courbe d'oscillation d'une triode Gunn de section trapézoïdale, soumise à une polarisation telle que sous la grille E > Ec
- fig. 8 : courbe donnant le champ électrique en fonction de la distance x à partir de la grille, dans une triode Gunn selon l'invention,
- fig. 9 : vue en plan d'une triode Gunn selon l'invention, donnant l'explication de son fonctionnement, pour une géométrie d'une première forme de réalisation,
- fig. 10 : courbe de réponse en fréquence, en fonction de la tension anode-cathode, d'une triode Gunn,
- fig. 11 : vue en plan d'une triode Gunn selon l'invention, dans une deuxième forme de réalisation,
- fig. 12 : courbe de réponse en fréquence, en fonction de la tension anode-cathode, de la triode Gunn de la figure précédente,
- fig. 13 : schéma en diagramme de bloc d'un oscillateur contrôlé en fréquence, par une boucle d'asservissement en phase utilisant l'invention.

L'effet Gunn et son application aux oscillateurs sont maintenant bien connus, mais le rappel de son fonctionnement permettra de mieux comprendre les phénomènes qui interviennent dans l'invention. A ce titre, un certain nombre de courbes fournies, en annexe sont déjà en soi connues, mais s'appliquent également à l'invention, puisque c'est la façon d'utiliser une triode Gunn, ou plus exactement de la polariser, qui constitue le fondement de l'invention.

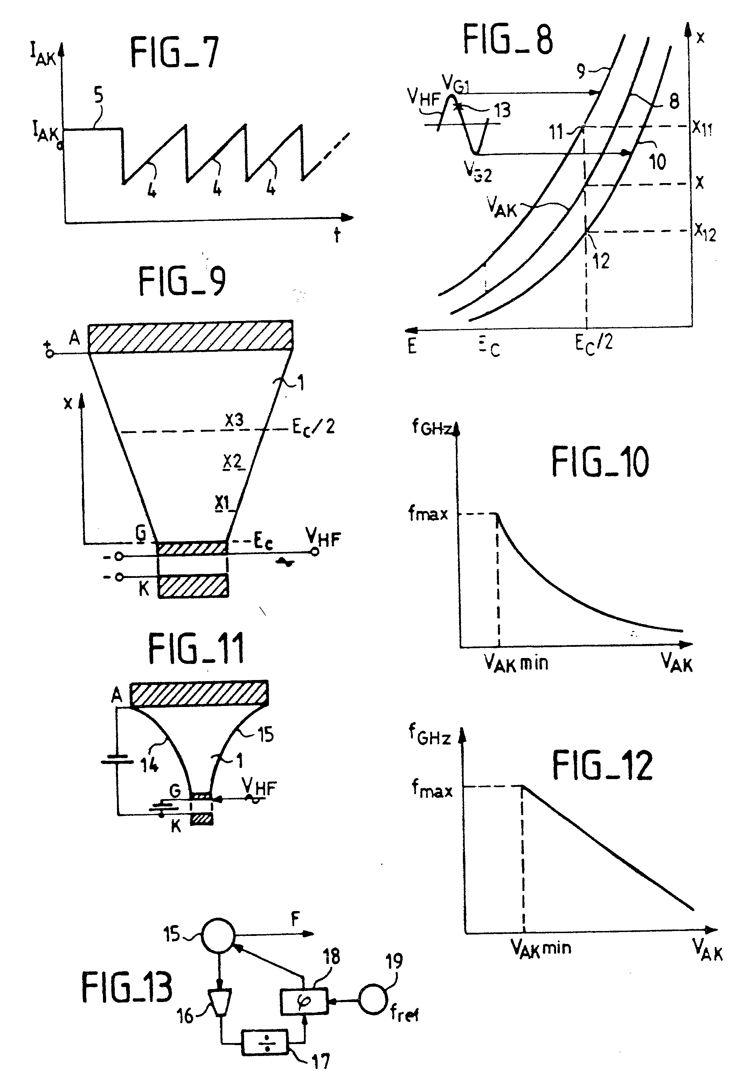

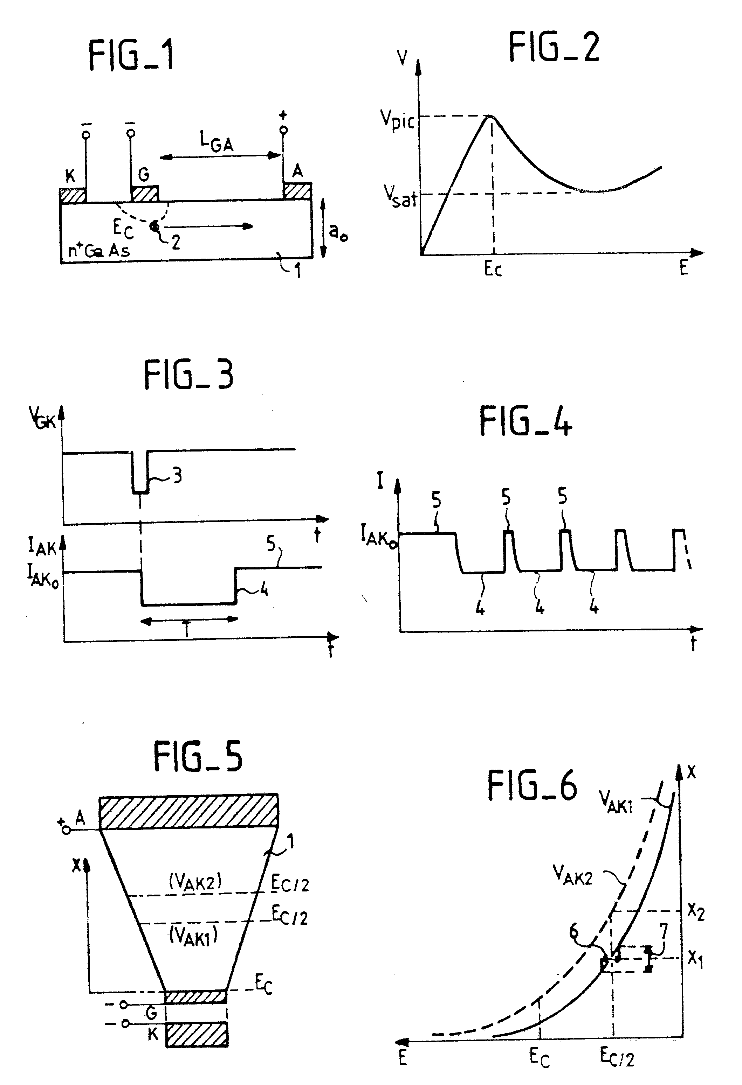

Un dispositif à effet Gunn est constitué, comme montré en figure 1, par un barreau 1 de matériau semiconducteur du groupe III-V, tel que Ga As ou In P, homopolaire et dopé de type n à un niveau de l'ordre de $5.10^{14}$ - $5.10^{15}$ at.cm$^{-3}$. Pour une diode Gunn, au moins une anode A et une cathode K sont déposées, sous forme de métallisations, aux extrêmités du barreau, qui a généralement un géométrie vue en plan, rectangulaire. Pour une triode, une métallisation de grille G est déposée sur le barreau 1, entre anode et cathode, à proximité de la cathode K. Une différence de tension de polarisation est appliquée entre anode et cathode.

Si on appelle :
- $n_o$ le taux de dopage du matériau semiconducteur,
- $L_{GA}$ la distance entre la grille et l'anode,
- $a_o$ l'épaisseur du barreau de matériau semiconduc-

teur,
il faut que :
$n_o L_{GA} > 10^{12} \, cm^{-2}$
et
$n_o a_o > 10^{11} \, cm^{-2}$
pour que le dispositif fonctionne selon l'effet Gunn.

On sait également que dans un bloc de matériau III-V uniformément dopé n, la mobilité des porteurs de charges, en fonction du champ électrique E, présente une variation négative dans un intervalle de champs, de sorte que la vitesse v des porteurs de charges, en fonction du champ électrique, est donnée par la courbe de la figure 2. Elle présente un maximum pour un champ dit critique $E_c$, auquel correspond une vitesse de pic $v_{pic}$, et un minimum dans la vallée, à $v_{sat}$.

Si une triode Gunn est polarisée par une tension telle qu'aucun point du barreau dans l'espace anode-cathode ne soit soumis à un champ supérieur au champ critique $E_c$, une impulsion négative (fig. 1) sur la grille, crée une charge d'espace, sous la grille, telle que le champ critique $E_c$ est atteint : les conditions de nucléation sont satisfaites. Un "domaine" 2 sous haut champ est créé sous le bord de la grille G, du côté de l'anode A. Il croît et se propage vers l'anode à une vitesse voisine de la vitesse limite des électrons, soit :
$10^7 \, cm.sec^{-1}$ dans Ga As. Arrivé à l'anode, le domaine s'éteint et le barreau 1 reprend son état initial, avant transfert d'électrons sous forme de paquets appelés domaines.

Ce phénomène est dû à une mobilité différentielle négative qui est causée par le transfert, dépendant du champ, des électrons de la bande de conduction depuis une vallée de faible énergie et haute mobilité vers une vallée de haute énergie et faible mobilité. Dans ces conditions, un excès de charge d'espace du côté de la cathode se déplace vers l'anode et croît exponentiellement comme conséquence de la mobilité différentielle négative.

Lorsque le taux de croissance est suffisamment important, ($n_o L_{GA} > 10^{12} cm^{-2}$ pour Ga As), un domaine sous haut champ se forme, et le champ à l'extérieur du domaine tombe à une valeur inférieure au champ critique $E_c$.

Il a été établi que, pour qu'un domaine existe et se propage, il faut qu'il soit soumis à un champ au moins égal à $E_c/2$.

La propagation d'un domaine est illustrée figure 3, sur laquelle le temps est porté en abscisses, la tension $V_{GK}$ appliquée à la grille G (diagramme supérieur) et le courant $I_{AK}$ dans le dispositif Gunn (diagramme inférieur) sont portés en ordonnées.

Une triode Gunn étant polarisée entre anode et cathode, si une impulsion 3 négative est appliquée sur la grille, un domaine se crée, avec un léger décalage dans le temps. Durant sa propagation vers l'anode, le courant $I_{AK}$ traversant la triode chute durant un temps T, égal au temps de transfert du domaine depuis la grille G jusqu'à l'anode A : il en résulte un créneau 4. La durée du créneau 4 est égale à :

$$T = \frac{L_{GA}}{v_{sat}}$$

$v_{sat}$ étant la vitesse limite des électrons dans le matériau considéré.

Dès que le domaine a atteint l'anode, le courant remonte à la valeur originale du courant de polarisation $I_{AK}$, en 5, mais durant le temps de transit d'un domaine, il ne peut pas y avoir nucléation d'un nouveau domaine.

Le diagramme de la figure 3 correspond au cas où le champ dans le barreau est inférieur au champ critique $E_c$, hormis au cours de l'impulsion, sous la grille.

Si par contre les conditions de polarisation $V_{AK}$ et $V_{GK}$ sont telles qu'en permanence le champ sous la grille est supérieur à $E_c$, il y a en permanence, de façon cyclique, nucléation d'un domaine, sa propagation vers l'anode et son extinction : le régime de fonctionnement est asynchrone. La structure oscille librement à une fréquence correspondant au temps de propagation des domaines dans l'espace grille-cathode, dépendant du profil de champ dans le barreau. La triode Gunn constitue alors un oscillateur asynchrone, pour lequel le diagramme du courant dans le temps est donné par la figure 4.

Une augmentation de $V_{AK}$ entraîne une variation de champ dans le dispositif qui modifie très légèrement la vitesse de saturation des domaines sous haut champ en transit dans l'espace grille-anode provoquant une légère variation de la fréquence d'oscillation libre de la structure. Mais dans ce cas-là la variation de fréquence n'excède jamais 1 à 2 % de la fréquence nominale donnée par la dimension géométrique $L_{GK}$ du barreau rectangulaire.

Tout ce qui précède concerne un dispositif Gunn pour lequel le barreau a une section uniforme, entre anode et cathode. Des dispositifs ayant une section non uniforme, telle que trapézoïdale, ont été décrits par M. Shoji dans Proceedings of the IEEE de janvier 1967, pages 130-131, et de mai 1967, pages 720-721, ainsi que dans IEEE Transactions on Electron Devices, vol. ED 11, n° 9, septembre 1967, pages 535-546.

La géométrie d'un tel dispositif, vue en plan, est donnée en figure 5. C'est une triode, dont le barreau de matériau semiconducteur 1 a une section trapézoïdale, dont l'anode A constitue la grande base et la grille G constitue la petite base. L'anode, la cathode et la grille sont soumises à une polarisation comme en figure 1. Dans cette structure, une plus étroite dépendance de la fréquence en fonction de la tension de polarisation est observée, parce que la section non uniforme introduit un gradient de champ électrique, entre la grille et l'anode.

Appelons x la distance mesurée depuis la grille, en direction de l'anode, et considérons la figure 6 qui donne la variation du champ électrique dans le barreau, en fonction de la distance x. Pour une triode trapézoïdale, la courbe est une hyperbole.

Pour une première valeur $V_{AK1}$ de polarisation, et la grille étant polarisée par une tension continue, un domaine prend naissance sous la grille, parce que le champ est au moins égal au champ critique $E_c$, et il se propage jusqu'en un point où le champ n'est plus que $E_c/2$, auquel correspond une distance $x_1$, et une fréquence $F_1$ : là, il s'éteint.

Pour une deuxième valeur $V_{AK2}$, supérieure par exemple à $V_{AK1}$, un domaine se propage jusqu'à une distance $x_2$, supérieure à $x_1$, puis s'éteint. La précision de réglage de ce type de VCO, dont le barreau est trapézoïdal, est très supérieure à celle d'un VCO dont le barreau est rectangulaire, parce que la fréquence est liée à la distance x parcourue par un domaine avant de s'éteindre.

Il y a cependant une légère imprécision sur la stabilité de la fréquence : en effet, un domaine qui se propage s'éteint lorsqu'il n'est plus soumis qu'à un champ $\frac{1}{2} E_c \mp \varepsilon$ représenté sur la figure 6 par un segment 6. Selon que le domaine s'éteint à $+\varepsilon$ ou à $-\varepsilon$ par rapport à $\frac{1}{2} E_c$, il a parcouru une distance un peu plus longue ou un peu plus courte que $x_1$, représentée par un segment 7. Comme la fréquence est liée à la distance x, la fréquence est légèrement instable.

Ce type de VCO est cependant très agile, et on peut commander sa variation de fréquence sur une seule période. Le courant fourni par un oscillateur Gunn à géométrie trapézoïdale est en dent de scie, tel que représenté en figure 7.

Dans les oscillateurs Gunn connus, la tension de polarisation appliquée sur la grille est continue, ou par impulsions négatives.

Selon l'invention, on superpose à la tension continue de polarisation de la grille ou de l'anode une tension alternative $V_{HF}$ dont la fréquence correspond à la fréquence d'oscillation libre d'un dispositif Gunn, ayant une section non uniforme entre anode et grille.

Le premier effet de cette superposition de deux tensions de polarisation est montré en figure 8, qui donne le champ électrique E en fonction de la distance x. A une tension continue, représentée par la courbe 8, est superposée une tension alternative $V_{HF}$ dont le maximum $V_{G1}$ suit la courbe 9 et le minimum $V_{G2}$ suit la courbe 10. Comme il y a superposition de deux tensions électriques, le champ $\frac{1}{2}E_c$ oscille entre deux valeurs repérées 11 et 12, en suivant les oscillations de la tension alternative $V_{HF}$. Un domaine qui se propage pourrait donc s'éteindre en un point situé entre une distance $x_{11}$ et une distance $x_{12}$. En fait, la théorie et l'expérience montrent qu'un domaine s'éteint lorsque la tension alternative commence à décroître, en un point tel que 13, et de façon très régulière.

Une onde extérieure alternative, superposée à la tension de polarisation, permet donc de resynchroniser la fréquence fournie par la triode Gunn, et l'onde de sortie est très pure et très stable.

En outre, si la tension alternative $V_{HF}$ n'est plus égale à la fréquence d'oscillation libre du dispositif-Gunn, mais est de la forme $f + \Delta f$, on oblige l'oscillateur à fonctionner à une fréquence qui n'est plus sa fréquence d'oscillation libre, et on observe encore cette resynchronisation dans une plage de fréquence de l'ordre de 5 à 10 % de la fréquence de commande. On a donc réalisé un vernier en fréquence, et si la triode Gunn oscille librement, par exemple à 10 GHz, on sait contrôler sa fréquence de sortie entre 9 et 11 GHz, avec un spectre très pur, dû à la superposition d'une tension alternative à la tension continue de polarisation.

Si, selon l'invention, on superpose à la tension continue de polarisation une tension alternative dont la fréquence est une harmonique de la fréquence d'oscillation librer du dispositif Gunn, on réalise un diviseur de fréquence. La figure 9 permet, en conjonction avec la figure 8, d'en comprendre le mécanisme.

Elle représente une vue en plan d'une triode Gunn, selon l'invention, dont la section anode-grille est trapézoïdale. La grille est polarisée en continu, positivement par rapport à la cathode, et une tension alternative $V_{HF}$, de fréquence harmonique, est superposée à la tension $V_{GK}$. Supposons, pour simplifier l'exposé, que la tension de commande $V_{HF}$ est l'harmonique 3 de la fréquence d'oscillation libre.

Lorsqu'un domaine se propage à partir de la grille, à la première période de la tension de commande, le domaine est en une position $x_1$ : il est soumis à un champ compris entre $E_c$ et $\frac{1}{2} E_c$ et il ne s'éteint pas au cours de la demie période décroissante de $V_{HF}$, puisqu'il est encore dans des conditions d'existence.

A la seconde période, le domaine est en une position $x_2$, et pour les mêmes raisons il existe toujours.

A la troisième période, le domaine atteint une position $x_3$ et comme il n'est plus soumis qu'à un champ inférieur ou égal à $\frac{1}{2} E_c$, il s'éteint, conformément à ce qui a été exposé pour la figure 8. La triode Gunn selon l'invention a donc fait une division par 3 de la fréquence d'entrée qui est la fréquence de commande.

De façon plus générale, si la fréquence de commande est une harmonique d'ordre N de la fréquence d'oscillation libre de la triode Gunn, celle-ci effectue une division d'ordre N.

Si la tension de commande est elle-même à une fréquence $f + \Delta f$ légèrement différente de la fréquence d'oscillation libre, elle impose au dispositif Gunn une resynchronisation identique à celle qui a été exposée précédemment. Dans une plage de fréquence dépendant du rang de l'harmonique ( $\Delta f = 5$ à 10 % de la fréquence) on peut donc régler avec précision la fréquence de sortie du dispositif Gunn : on a donc réalisé un vernier pour un diviseur de fréquence dynamique.

En résumé, pour le diviseur programmable selon l'invention, on dispose de trois moyens de contrôle de la fréquence de sortie :
- en faisant varier la tension de polarisation $V_{AK}$, on obtient une fréquence de sortie de rang fixe, selon la courbe de la figure 10 qui correspond à l'art connu,
- en appliquant sur la grille une tension de fréquence harmonique de la fréquence d'oscillation libre, on obtient un diviseur de fréquence de rang variable,
- en appliquant en outre sur la grille une tension dont la fréquence diffère d'un $\Delta f$ d'une harmonique de la fréquence d'oscillation libre, on obtient un diviseur de fréquence avec vernier.

Toutefois, c'est un inconvénient, si on considère la courbe de réponse de la figure 10, qu'un oscillateur ou un diviseur de fréquence ait une réponse en fréquence qui ne soit pas linéaire avec la tension de polarisation $V_{AK}$. Il est connu que cette courbe de réponse, en figure 10, de même que les courbes de champ électrique en figures 6 et 8, sont des hyperboles. Cependant, il est plus pratique pour les utilisateurs de disposer d'un matériel qui ait une réponse linéaire avec la commande.

L'invention apporte une solution à ce problème avec le dispositif Gunn de la figure 11. Il s'agit d'une triode Gunn dont la couche de Ga As ou In P située ente anode et grille est délimitée latéralement par deux bords 14 et 15 qui ont une forme d'hyperbole. Ainsi, le grandient de champ qui existe dans la triode Gunn présente une variation linéaire, qui fournit au dispositif Gunn une courbe de réponse linéaire selon la figure 12.

La réalisation d'une triode Gunn selon l'invention est aisée. Sur un substrat isolant ou semi-isolant, qui est avantageusement en matériau semiconducteur, est déposée une couche de 1 à 2 microns d'épaisseur de matériau III-V tel que Ga As ou In P, dopé de type n à $5.10^{14}$ - $5.10^{15}$ at.cm$^{-3}$ par implantation. Les trois métallisations d'anode, cathode et grille sont déposées selon les techniques habituelles en technologie planar. Mesurées selon l'axe anode cathode, l'anode a 5 microns de longueur, la région trapézoïdale ou hyperbolique mesure 20 microns, la grille 1 micron, l'espace grille cathode 2 microns, et la cathode 5 microns, soit 33 microns au total. Les tensions appliquées sont comprises entre 5 et 15 V, et le dispositif oscille ou divise depuis environ 1 GHz jusque 60 GHz.

Une application en est donnée en figure 13, qui représente une boucle de synthèse de fréquence. Soit 15 un oscillateur dont on veut asservir la fréquence de sortie F comprise entre 10 et 60 GHz. Il excite un diviseur de fréquence dynamique programmable 16, selon l'invention, qui fournit en sortie une fréquence très précise, très pure, mais encore trop élevée (quelques gigahertz) pour pouvoir asservir l'oscillateur. Un second diviseur de fréquence 17, réalisé soit en silicium soit en Ga As, divise encore cette fréquence, et l'adresse sur un comparateur de phase 18 simultanément excité par un signal délivré par une source de fréquence de référence 19 qui asservit avec précision l'oscillateur contrôlé en tension 15. Le dispositif Gunn est alors inclus dans la boucle à verrouillage de phase réalisée par les éléments 16, 17, 18 et 19.

La réalisation planar de la triode Gunn selon l'invention permet de l'intégrer dans des circuits intégrés, et ainsi de réaliser, par exemple, l'ensemble de l'oscillateur 15 et de sa boucle de synthèse 16 + 17 sur une même pastille, en monolithique.


**Revendications**


1. Dispositif triode Gunn, fonctionnant à très hautes fréquences (1 à 60 GHz), et comportant, supporté par un substrat, une couche (1) de matériau semiconducteur de la famille III-V, munie de trois métallisations, anode (A) à une première extrémité de la couche (1), cathode (K) à une deuxième extrêmité de la couche (1), et grille (G) à proximité de la cathode (K), ce dispositif ayant une fréquence d'oscillation libre lorsqu'il est polarisé par une tension ($V_{AK}$) entre anode et cathode, et que la grille est polarisée par une tension continue ($V_{GK}$), et étant caractérisé en ce que :
- la couche (1) de matériau semiconducteur, située entre les métallisations d'anode (A) et de grille (G) a une largeur non uniforme, l'anode (A) étant plus large que la grille (G),
- la grille (G) ou l'anode (A) sont polarisées par une tension de commande alternative ($V_{HF}$) superposée aux tensions continues ($V_{GK}$ ou $V_{AK}$), ladite tension alternative ayant une fréquence qui est une harmonique de la fréquence d'oscillation libre de la triode Gunn.

2. Dispositif triode Gunn selon la revendication 1, caractérisé en ce que la couche (1) de matériau semiconducteur, entre anode et grille, a une géométrie trapézoïdale, dont la grande base est constituée par l'anode (A) et la petite base constituée par la grille (G).

3. Dispositif triode Gunn selon la revendication 1, caractérisé en ce que la couche (1) de matériau semiconducteur, entre anode et grille, est limitée latéralement par deux bords (14, 15) ayant une forme hyperbolique, et a une forme trapézoïdale curviligne, dont la grande base est constituée par l'anode (A) et la petite base constituée par la grille (G).

4. Dispositif triode Gunn selon la revendication 1, caractérisé en ce qu'une variation ($\Delta$ f) de la fréquence (f $\pm$ $\Delta$ f) de la tension de commande ($V_{HF}$) de la grille permet d'ajuster la fréquence de sortie, par resynchronisation et constitue un vernier de fréquence.

5. Dispositif triode Gunn selon la revendication 4, caractérisé en ce qu'il constitue un diviseur dynamique de la fréquence d'oscillation libre, ce diviseur de fréquence étant :
- de rang variable, selon l'ordre de l'harmonique de nombre entier de la fréquence de commande ($V_{HF}$),
- programmable selon la variation ($\Delta$ f) de cette fréquence de commande (f $\pm$ $\Delta$ f) par rapport à l'harmonique de nombre entier.

6. Dispositif triode Gunn selon la revendication 1, caractérisé en ce qu'il constitue un diviseur dynamique de la fréquence ($V_{HF}$) appliquée sur sa grille ou sur son anode, le rang fixe de division étant commandé par la tension continue de polarisation anode-cathode ($V_{AK}$).

7. Dispositif triode Gunn selon la revendication 1, caractérisé en ce qu'il constitue un oscillateur commandé en tension, dont la fréquence de sortie est programmable par une tension alternative $V_{HF}$.

8. Dispositif triode Gunn selon la revendication 3, caractérisé en ce que sa réponse en fréquence est linéaire par rapport à sa tension de polarisation anode-cathode ($V_{AK}$).

9. Dispositif triode Gunn selon l'une quelconque des revendications précédentes, caractérisé en ce qu'il est intégré dans la pastille d'un circuit intégré en matériau III-V (Ga As, In P).

FIG_7

FIG_8

FIG_9

FIG_10

FIG_11

FIG_12

FIG_13

FIG_1

FIG_2

FIG_3

FIG_4

FIG_5

FIG_6

Office européen
des brevets

RAPPORT DE RECHERCHE EUROPEENNE

Numero de la demande

EP  88 40 2013

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | PROCEEDINGS FIFTH BIENNIAL CORNELL ELECTRICAL ENGINEERING CONFERENCE, 1975, Topic: "Active semiconductor devices for microwaves and integrated optics", Ithaca, New York, 19-21 août 1975, pages 195-203, IEEE, Inc.; D. CLAXTON et al.: "High ratio frequency division with three-terminal gunn effect devices" * Page 196, paragraphe 2 * | 1,2 | H 01 L  47/02 H 03 B  19/14 |
| A | Idem --- | 4-9 | |
| Y | FR-A-2 026 423  (WESTERN ELECTRIC CO.) * Revendications 1,2; figures 1,3 * | 1,2 | |
| A | | 4-9 | |
| A | US-A-4 023 196  (S. KATAOKA et al.) * Figure 7 * --- | 3 | |
| A | US-A-3 538 400  (H. YANAI et al.) ----- | | |

| DOMAINES TECHNIQUES RECHERCHES (Int. Cl.4) |
|---|
| H 01 L  47 H 03 B  19/14 |

Le présent rapport a été établi pour toutes les revendications

| Lieu de la recherche | Date d'achèvement de la recherche | Examinateur |
|---|---|---|
| LA HAYE | 10-11-1988 | PELSERS L. |

EPO FORM 1503 03.82 (P0402)